# EUROPÄISCHE PATENTANMELDUNG

(11) **EP 2 432 011 A1**
(43) Veröffentlichungstag der Anmeldung: **21.03.2012**
(21) Anmeldenummer: 11181301.0
(22) Anmeldetag: 14.09.2011
(51) Int. Cl.: H01L 21/687, H01L 21/67

(54) **Vorrichtung zur Behandlung und/oder Bearbeitung von Substraten**

(30) Priorität: 15.09.2010 DE 102010045411
(71) Anmelder: Beier, Uwe, 01458 Ottendorf-Okrilla (DE)
(72) Erfinder: Beier, Uwe, 01458 Ottendorf-Okrilla (DE)
(74) Vertreter: Carlsohn, Alexander

(57) **Zusammenfassung**

Die Erfindung betrifft eine Vorrichtung zur Behandlung und/oder Bearbeitung von Substraten (4). Dabei ist vorgesehen, dass die Vorrichtung
- einen von einem Gehäuse (1) abgeschlossenen Raum (2) mit zumindest einer verschließbaren Öffnung zur Einbringung und/oder Ausbringung eines Substrates (4); und
- zumindest eine erste Handhabungseinrichtung (6) für das Substrat (4), wobei die erste Handhabungseinrichtung (6) eine erste Ebene (8) und zumindest einen Antrieb (9) zur Verschiebung der ersten Ebene (8) in Richtung der Flächennormalen der ersten Ebene (8) aufweist,
wobei die erste Ebene (8) der ersten Handhabungseinrichtung (6) innerhalb des abgeschlossenen Raumes (2) angeordnet ist und wobei der Antrieb (9) zur Verschiebung der ersten Ebene (8) außerhalb des abgeschlossenen Raums (2) angeordnet ist.

## Beschreibung

Die Erfindung betrifft eine Vorrichtung zur Behandlung und/oder Bearbeitung von Substraten, insbesondere von flächigen Substraten, in einem abgeschlossenen Raum.

Aus dem Stand der Technik ist die Behandlung, beispielsweise die Oberflächenbehandlung, und/oder Bearbeitung von flächigen Substraten in abgeschlossenen Räumen bekannt. Der Vorteil eines abgeschlossenen Raums besteht darin, dass in dem Raum Bedingungen geschaffen werden können, die sich von den Umgebungsbedingungen unterscheiden. Beispielsweise können Druck, Temperatur, chemische Zusammensetzung der Gasphase usw., in einem abgeschlossenen Raum verändert werden.

Im Falle einer Vakuumprozessanlage ist der abgeschlossene Raum eine Vakuumkammer, in der beispielsweise Beschichtungen von Glassubstraten oder Wafern bei vermindertem Druck und hohen Temperaturen vorgenommen werden können. Typischerweise weist die Vakuumkammer Einrichtungen auf, die den Transport flächigen Substrates von einer Eintrittsöffnung durch die Vakuumkammer zu einer Austrittsöffnung ermöglichen sollen. Ferner sind Behandlungseinrichtungen wie Beschichtungsquellen oder Ätzeinrichtungen vorgesehen. Überdies kann die Vakuumkammer zusätzlich Heizeinrichtungen, Kühleinrichtungen, Beleuchtungen, Messtechnik und weitere Komponenten enthalten. Um das Vakuum in der Kammer schnell auf- und abbauen zu können und damit kurze und wirtschaftliche Bearbeitungszeiten zu erreichen, müsste das Innenvolumen der Vakuumkammer möglichst klein gehalten werden. Die Aufnahme der Behandlungseinrichtungen, Transporteinrichtungen usw. in die Vakuumkammer ist jedoch zwangsläufig mit einer Vergrößerung des Innenvolumens der Kammer verbunden, was die Herstellung der gewünschten Bedingungen in der Kammer erschwert.

Die Einrichtungen, die sich in der Kammer befinden, müssen überdies an die in der Vakuumkammer vorgesehenen Bedingungen angepasst sein. Die Einrichtungen müssen unter anderem vakuumbeständig, chemisch beständig und temperaturbeständig sein, was einerseits die Herstellung dieser Einrichtungen verteuert und andererseits den Einsatz einer Vielzahl von Einrichtungen oder Komponenten dieser Einrichtungen ausschließt, die bei Umgebungsbedingungen eingesetzt werden könnten. Aus diesem Grunde ist beispielweise der Einsatz vieler üblicher Antriebe ausgeschlossen. Aufgabe der Erfindung ist es, die Nachteile nach dem Stand der Technik zu beseitigen. Es soll insbesondere eine Vorrichtung zur Behandlung und/oder Bearbeitung von Substraten in einem abgeschlossenen Raum angegeben werden, die den Einsatz herkömmlicher Antriebe erlaubt.

Diese Aufgabe wird durch die Merkmale des Anspruchs 1 gelöst. Zweckmäßige Ausgestaltungen der Erfindungen ergeben sich aus den Merkmalen der Ansprüche 2 bis 10.

Nach Maßgabe der Erfindung ist eine Vorrichtung zur Behandlung und/oder Bearbeitung von Substraten vorgesehen, die
- einen von einem Gehäuse abgeschlossenen Raum mit zumindest einer verschließbaren Öffnung zur Einbringung und/oder Ausbringung eines Substrates; und
- zumindest eine erste Handhabungseinrichtung für das Substrat, wobei die erste Handhabungseinrichtung eine erste Ebene und zumindest einen Antrieb zur Verschiebung der ersten Ebene in Richtung der Flächennormalen der ersten Ebene aufweist,
umfasst, wobei die erste Ebene der ersten Handhabungseinrichtung innerhalb des abgeschlossenen Raumes angeordnet ist und wobei der Antrieb zur Verschiebung der ersten Ebene außerhalb des abgeschlossenen Raums angeordnet ist.

Vorzugsweise umfasst die erfindungsgemäße Vorrichtung ferner eine zweite Handhabungseinrichtung, die eine zweite Ebene und zumindest einen Antrieb zur Verschiebung der zweiten Ebene in Richtung der Flächennormalen der zweiten Ebene aufweist, wobei die zweite Ebene der zweiten Handhabungseinrichtung der ersten Ebene der ersten Handhabungseinrichtung gegenüberliegt. Alternativ kann die zweite Ebene in Richtung der Flächennormalen der zweiten Ebene starr angeordnet sein.

Sind eine erste und eine zweite Handhabungsvorrichtung vorgesehen, so kann das Substrat zwischen die beiden Ebenen, d. h. die erste Ebene und die zweite Ebene, eingebracht werden.

Die erste Ebene wird im Folgenden auch als Hauptebene bezeichnet. Die der Hauptebene gegenüberliegende zweite Ebene der zweiten Handhabungseinrichtung wird auch als Gegenebene bezeichnet. Wird im Folgenden allgemein von einer Ebene gesprochen, so bezieht sich dies auf Merkmale, die die erste Ebene und/oder die zweite Eben aufweisen können.

Die Bewegung einer Ebene in Richtung der Flächennormalen dieser Ebene kann in positiver als auch in negativer Richtung erfolgen. Die Bewegung ist vorzugsweise eine gleichförmige Bewegung. Im Folgenden wird eine Bewegung in Richtung der Flächenormalen dieser Ebene auch als Querbewegung oder Hubbewegung bezeichnet. Im Gegensatz dazu wird eine Bewegung des Substrates in der Ebene oder parallel zu dieser als Transportbewegung bezeichnet.

Die Bewegung einer Ebene in Richtung ihrer Flächennormalen kann nicht nur zur Änderung der Position eines Substrates genutzt werden, sondern auch zur Behandlung und/oder Bearbeitung des Substrates, beispielsweise in dem die Kraft, die zur Bewegung der Hauptebene genutzt werden kann, dazu benutzt wird, das Substrat gegen die Gegenebene zu pressen. Auf diese Weise kann beispielsweise eine Formänderung des Substrates erreicht werden. Neben Formänderungen des Substrates können die Handhabungseinrichtungen insbesondere auch für Richtprozesse, Verbindungsprozesse, Testprozeduren, die an dem Substrat ausgeführt werden sollen, genutzt werden. Einer der Vorteile der erfindungsgemäßen Vorrichtung ist die Möglichkeit, herkömmliche Antriebe zu verwenden, um innerhalb des abgeschlossenen Raumes eine Hubbewegung einer Ebene zu bewirken. Durch die räumliche Trennung von Antrieb und Ebene ist es möglich, innerhalb des abgeschlossenen Raumes das Substrat mittels der Handhabungseinrichtung exakt zu bewegen, ohne dass ein Antrieb für diese Bewegung in dem abgeschlossenen Raum selbst vorgesehen ist. Durch die Verlagerung des Antriebes aus dem abgeschlossenen Raum in die Umgebung ist es möglich, das benötigte Innenvolumen des abgeschlossenen Raumes zu verkleinern, ohne auf die Möglichkeit, das Substrat die beschriebene Bewegung in Richtung der Flächennormalen der Ebene ausführen zu lassen, verzichten zu müssen. Ein vergleichsweise geringes Innenvolumen des abgeschlossenen Raumes ermöglicht wiederum, die technischen Aufwendungen, die mit der Schaffung der besonderen raumklimatischen Bedingungen in dem abgeschlossenen Raum verbunden sind, zu verringern. Die vorliegende Erfindung ermöglich somit sowohl eine Verringerung der Kosten für die Herstellung einer Vorrichtung zur Behandlung und/oder Bearbeitung von Substraten in einem abgeschlossenen Raum als auch eine Verringerung der Kosten für den Betrieb einer solchen Vorrichtung. Hinzu kommt, dass die außerhalb des abgeschlossenen Raumes eingesetzten Antriebe nicht den raumklimatischen Bedingungen in dem abgeschlossenen Raum ausgesetzt werden, so dass herkömmliche Antriebe eingesetzt werden können, deren Materialien und Oberflächen beispielsweise nicht vakuum-, temperatur- und chemikalienbeständig sein müssen. Die Verwendung herkömmlicher Komponenten für die Antriebe verringert die Kosten für die Herstellung der erfindungsgemäßen Vorrichtung weiter.

Um eine möglichst exakte Bewegung der ersten Ebene und/oder zweiten Ebene sicherzustellen, sind zweckmäßigerweise zwei oder mehr Antriebe zur Bewegung der jeweiligen Ebene der Handhabungseinrichtung vorgesehen, wobei jeder der Antriebe außerhalb des geschlossenen Raumes angeordnet ist. Die Antriebe einer Ebene sind vorzugsweise über Steuereinrichtungen miteinander verbunden. Die Antriebe können beispielsweise mechanisch und/oder elektrisch miteinander verbunden sein. Mehrere Antriebe für die Bewegung einer Ebene ermöglichen eine exakte Bewegung der Ebene und die Aufrechterhaltung der Ebene innerhalb sehr enger Toleranzen auch unter erschwerten Bedingungen in dem abgeschlossenen Raum.

Sind mehrere Antriebe vorgesehen, so wird die Ebene vorzugsweise in Teilflächen annähernd gleicher Größe zerlegt, wobei jede Teilfläche dann mittels eines gesonderten Antriebs verschoben wird. Aufgrund der Verbindung zwischen den Antrieben einer Ebene werden die Teilflächen weitestgehend gleichzeitig um die gleiche Strecke verschoben, so dass eine exakte Bewegung der Ebene erreicht wird. In einer Ausführungsform der Erfindung können auch mehrere Antriebe zum Verschieben einer Teilfläche vorgesehen sein.

Die Verbindung zwischen der Ebene der Handhabungseinrichtung innerhalb des abgeschlossenen Raumes und einem Antrieb der Handhabungseinrichtung außerhalb des abgeschlossenen Raumes wird vorzugsweise über eine Durchführung in dem Gehäuse realisiert. Durch die Durchführung ist ein Stellelement, beispielsweise eine Welle, Achse oder Stange wie eine Kolbenstange, geführt, mit dessen Hilfe die vom Antrieb erzeugte Bewegung auf die Ebene übertragen wird, so dass diese die vorgegebene Bewegung in Richtung ihrer Flächenormalen ausführt, wodurch eine Verschiebung der Ebene erreicht wird. Zweckmäßigerweise sind die Durchführungen mittels Dichtungen abgedichtet, um eine Angleichung der Bedingungen in dem abgeschlossenen Raum an die Umgebungsbedingungen zu verhindern.

Alternativ zu einer Durchführung, durch die ein Stellelement geführt wird, kann die von einem Antrieb erzeugte Bewegung auch mittels mehrerer Stellelemente auf die Ebene der Handhabungseinrichtung übertragen werden. In einer bevorzugten Ausführungsform sind zwei Stellelemente pro Antrieb vorgesehen, wobei das erste Stellelement außerhalb des abgeschlossenen Raumes angeordnet ist und sich das zweite Stellelement in den abgeschlossenen Raum erstreckt. Eine Fläche des zweiten Stellelementes bildet dabei einen beweglichen Teil des Gehäuses. Ist die Durchführung ein Membranbalg so kann das erste Stellelement ebenso eine Welle, Achse oder Stange wie eine Kolbenstange sein, deren Ende auf die besagte Fläche des zweiten Stellelementes einwirkt. Dabei wird das Stellelement in Richtung der Flächennormalen der Ebene verschoben. Die Dichtheit des Gehäuse wird durch einen Membranbalg gewährleistet. Der Membranbalg hat typischerweise einen rohrförmigen Querschnitt, wobei die eine Stirnseite dieses rohrartiges Gebildes von der besagten Fläche des Stellelementes verschlossen ist, während die andere Stirnseite an dem - im Verhältnis zu den Stellelementen starren -Teil des Gehäuses befestigt sind. Der Membranbalg ist somit nur an einer Stirnseite geöffnet. In diese Öffnung ist das Stellelement eingeführt, so dass sich ein Ende des ersten Stellelementes in Kontakt mit der besagten Fläche des zweiten Stellelementes befindet.

Die Realisierung einer Durchführung mittels eines Membranbalgs ist besonders vorteilhaft, weil eine solche Durchführung absolut hermetisch dicht ist, reibungsfrei funktioniert, beständig gegen Chemikalien und Temperaturen ist, mechanisch robust ist und eine hohe Lebensdauer aufweist. Im Gegensatz zu einer Durchführung mit Dichtung, bei der die Kolbenstange in den abgeschlossenen Raum hineinragt, ermöglicht ein Membranbalg eine vollständige Trennung des abgeschlossenen Raumes von der Umgebung.

Soll das Substrat einer thermischen Behandlung unterzogen werden, so wird die Verbindung zwischen der Ebene und jedem ihrer Antriebe zweckmäßigerweise so gestaltet, dass sich die Materialien ausdehnen können, was durch eine Funktionstrennung von Führung und Antrieb realisiert werden kann.

Das Substrat ist vorzugsweise ein flächiges Substrat, beispielsweise ein scheibenförmiges Gebilde wie eine Glasplatte, ein Blech, eine Folie oder ein Komposit aus mehreren Schichten, wie beispielsweise ein Wafer oder ein Solarmodul. Mittels der erfindungsgemäßen Vorrichtungen können beispielsweise Displayscheiben, Architekturglas, Solarsubstrate, Halbleiter usw. bearbeitet wie zum Beispiel beschichtet werden. Das flächige Substrat liegt zweckmäßigerweise auf der Ebene auf. Der Begriff "flächiges Substrat" kann auch ein Substrat umfassen, das aus mehreren, räumlich getrennten Einheiten besteht, die auf der Ebene aufliegen. Insbesondere können statt eines großflächigen Substrates mehrere im Vergleich hierzu kleinere Substrate auf einer Ebene aufliegen.

Unter dem Ausdruck "Behandlung und/oder Bearbeitung von Substraten" wird insbesondere die Bearbeitung, Verarbeitung, Veredelung, Formänderung, Temperierung, Bestrahlung und Testung von Substraten sowie Kombinationen davon verstanden.

Unter Ebene wird in der vorliegenden Erfindung eine Fläche verstanden, auf der Substrat vollflächig aufliegen kann. Dabei kann die Ebene die Oberfläche eines Elementes sein. Da die Ebene erfindungsgemäß in Richtung ihrer Flächennormalen bewegt werden kann, wird dieses Element im Folgenden als Hubelement bezeichnet, wobei der Ausdruck "Hub" nur die Eigenschaft des Elementes beschreiben soll, eben eine Bewegung der Ebene des Elementes in Richtung der Flächennormalen ausführen zu können.

Die Fläche des Hubelementes, die die Ebene bildet, kann eine beliebige Kontur aufweisen. Sie kann beispielsweise eine dreieckige, quadratische, rechteckige, kreisförmige oder polygonale Fläche sein. Vorzugsweise ist diese Fläche die Oberfläche einer Platte, beispielsweise einer Metallplatte. Eine solche Platte kann aus Teilelementen zusammengesetzt sein. Beispielsweise kann sie aus mehreren Segmenten und/oder Schichten aufgebaut sein. Ein Aufbau der Platte aus mehreren Segmenten erleichtert die Fertigung des Hubelementes, dessen Montage und Handhabung. Ein Aufbau der Platte aus mehreren Schichten erleichtert die Integration von Aktoren, Sensoren, Temperiereinrichtungen und anderer Einrichtungen in die Platte. Ferner kann die Oberfläche der Platte, die die Ebene bildet und auf der das Substrat aufliegen kann, mit einer Beschichtung versehen sein, die einen schonenden Substratkontakt ermöglicht.

Die Hubelemente können ferner Aussteifungen, beispielsweise Rippen, aufweisen, die die Fläche, die die Ebene bildet, stabilisieren und so Verformungen der Fläche verhindern.

Das Hubelement kann mit Einrichtungen ausgerüstet sein, die für die Behandlung und/oder Bearbeitung des Substrates von Nutzen sind. Derartige Einrichtungen umfassen beispielsweise Kühlelemente, Heizelemente, Aktoren, Sensoren, Gaseinlässe (z. B. für technische Gase), Verdampfer, Einrichtungen zur Beschichtung des Substrates (z. B. Sputterquellen), Einrichtungen zum Testen des Substrates, Beleuchtungselemente, Magnetsysteme, Messinstrumente, Einrichtungen zum Transport des Substrates und Kombinationen davon.

Eine Einrichtung zum Transport des Substrates kann beispielsweise den Substrattransport in vertikaler, horizontaler oder beliebiger Winkellage auf der Ebene ermöglichen. Dazu können beispielsweise Kugelrollen, Stützrollen, Antriebsrollen, Antriebswellen, Riemen, Schrittgetriebe, Hubbalken in das Hubelement integriert sein. In einer Ausführungsform kann ein Bandförderer, dessen Obertrum in der Ebene bewegbar ist, auf der das Substrat aufliegt, vorgesehen sein. Sind Räder, Rollen oder Wellen zum Transport des Substrates vorgesehen, sollten deren Drehachsen parallel zu der Ebene in dem Hubelement verlaufen und deren Radius dem Abstand zwischen ihrer Drehachse und der Ebene entsprechen, so dass die Mantelflächen der Räder, Rollen oder Wellen in Kontakt mit der Unterseite des Substrates gelangen können.

Die Einrichtungen für die Behandlung/oder Bearbeitung des Substrates können in die Handhabungseinrichtungen, insbesondere in die Hubelemente integriert sein. Selbstverständlich können die Einrichtungen für die Behandlung und/oder Bearbeitung des Substrates auch räumlich getrennt von den Handhabungseinrichtungen in dem geschlossenen Raum angeordnet sein. Beispielsweise können Transporteinrichtungen wie Bandförderer vorgesehen sein, die ein Substrat von der Eingangsöffnung des abgeschlossenen Raums bis zu der Hauptebene transportieren und das Substrat dort an die erste Handhabungsvorrichtung übergeben, wozu die Hauptebene auf die Höhe der Fläche der Transportvorrichtung, auf der das Substrat aufliegt, angehoben oder abgesenkt werden kann. Ebenso kann eine weitere Transporteinrichtung vorgesehen sein, die das Substrat von der Hauptebene nach der Behandlung und/oder Bearbeitung des Substrates zu einer Ausgangsöffnung befördert.

Die Auswahl und die Anordnung dieser Einrichtungen sind dem Fachmann aus seinem Fachwissen bekannt.

Um eine exakte und gleichmäßige Bewegung einer Ebene zu gewährleisten, kann es erforderlich sein, dass die Handhabungseinrichtungen zusätzlich Führungen aufweisen. Dies ist insbesondere dann zweckmäßig, wenn Substrate mit großer Flächenausdehnung, beispielsweise Glasplatten, in der Vorrichtung bearbeitet werden sollen, wenn Heiz- oder Kühleinrichtungen in das Hubelement integriert sind oder beides. Die Handhabungseinrichtung kann daher eine oder mehrere Führungen umfassen. In einer bevorzugten Ausführungsform ist eine Führung mittig zur Ebene vorgesehen (die im Folgenden als Zentralführung bezeichnet wird) und zumindest eine weitere Führung, die von der Mitte der Ebene und vom Rand der Ebene beabstandet ist. Diese weiteren Führungen werden im Folgenden als periphere Führungen bezeichnet.

Die Zentralführung ist vorzugsweise ein Festlager. Mittels eines solchen Lagers kann eine gleichmäßige thermische Ausdehnung der Ebene in alle Richtungen gewährleistet werden. Überdies sind die Beträge der Ausdehnung an den Rändern der Ebene jeweils gleich, da die Ausdehnung von der Mitte bis zum Rand der Ebene die Hälfte der Gesamtausdehnung der Ebene beträgt. Das Festlager verhindert alle Bewegungen der Ebene, abgesehen von der Bewegung in Richtung ihrer Flächennormalen. Wird in einem kartesischen Koordinatensystem die Flächennormale als z-Achse bezeichnet, so erstreckt sich die Ebene entlang der x- und y-Koordinate. Mit dem Festlager werden also Bewegungen in x,y-Richtung verhindert, Bewegungen in z-Richtung sind jedoch zulässig.

Die peripheren Führungen sind vorzugsweise Loslager. Mittels eines solchen Lagers wird eine Verdrehung der Ebene verhindert, während die Ausdehnung der Ebene in Längsrichtung jedoch möglich ist. Die Loslager verhindern die Bewegung nur in x- oder y-Richtung, so dass Bewegungen der Ebene in z-Richtung und in y-Richtung (wenn die Bewegung in x-Richtung von dem Loslager verhindert wird) oder in z-Richtung und in x-Richtung (wenn die Bewegung in y-Richtung von dem Loslager verhindert wird) möglich sind. Sind mehrere Loslager vorgesehen, so ermöglichen sie zweckmäßigerweise eine Bewegung der Ebene in denselben Richtungen, d. h. alle Loslager ermöglichen die Bewegung der Ebene in z-Richtung und in x-Richtung oder in z-Richtung und in y-Richtung. Vorzugsweise ermöglichen die Loslager die Bewegung der Ebene in z-Richtung sowie in Richtung der längsten Ausdehnung der Ebene.

Zur Führung einer Ebene kann vorgesehen sein, dass an der Seite des Hubelementes, die der Ebene abgewandt ist, Führungselemente ausgebildet sind, beispielsweise Führungsstangen, deren Längsachsen orthogonal zu der Ebene verlaufen. Diese Führungsstangen sind zwischen einstellbare Führungsrollen gespannt, deren Drehachsen orthogonal zu den Längsachen der Führungsstangen verlaufen und deren Mantelflächen sich in Kontakt mit den Führungsstangen befinden. Im Falle eines Festlagers sind beispielsweise drei oder vier Führungsrollen vorgesehen, deren Drehachsen in einer Ebene liegen, wobei die Drehachsen benachbarter Führungsrollen in einem Winkel von 120° oder 90° zueinander verlaufen. Im Fall eines Loslagers sind beispielsweise zwei Führungsrollen vorgesehen, deren Drehachsen in einer Ebene liegen, wobei die Drehachsen beider Führungsrollen parallel zueinander verlaufen. Die Führungsrollen für das Festlager und die Nebenlager sind vorzugsweise an Lagerblöcken drehbar befestigt, wobei die Lagerblöcke wiederum an dem Gehäuse befestigt sein können. Zweckmäßigerweise ist für jede Rolle ein gesonderter Lagerblock vorgesehen.

Insbesondere im Falle langer Führungsstangen können in dem Gehäuse Öffnungen ausgebildet sein, durch die die Führungsstangen verlaufen. Diese Öffnungen sind durch Verschlüsse, beispielsweise in Form von Hauben, verschlossen, die den Teil der Führungsstangen, die durch die Öffnungen aus dem Gehäuse herausragen, umschlie-ßen. Dies hat den Vorteil, dass sich das Volumen des abgeschlossenen Raumes nur geringfügig erhöht.

Sollen in der erfindungsgemäßen Vorrichtung Substrate thermischen Prozessen unterzogen werden, so kann es vorteilhaft sein, wenn auch die Handhabungseinrichtung, die die Gegenebene umfasst, derartige Führungen aufweist. Die ist auch bei einer starren Gegenebene vorteilhaft. Die starre Gegenebene führt zwar keine Bewegungen in Richtung ihrer Flächennormalen aus, eine thermische Ausdehnung in der Gegenebene in x- und/oder y-Richtung ist jedoch möglich.

Unter einem abgeschlossenen Raum wird hier ein Raum verstanden, der mittels eines Gehäuses von der Umgebung möglichst vollständig getrennt werden kann. In dem Gehäuse können Öffnungen vorgesehen sein, beispielsweise um das Substrat in den Raum einbringen zu können. Ferner sind in dem Gehäuse Durchführungen ausgebildet, durch die die Stellelemente der Handhabungseinrichtung geführt sind. Öffnungen in dem Gehäuse müssen verschließbar sein und/oder mittels Dichtungen abgedichtet sein, so dass ein Kontakt zwischen dem von dem Gehäuse umschlossenen Raum und der Umgebung so weit wie möglich verhindert wird. Je nach Verwendungszweck der erfindungsgemäßen Vorrichtung kann der abgeschlossene Raum beispielsweise als Kammer, Vakuumkammer, Box, Rezipient, Reaktor, Testumgebung, Prozessraum usw. bezeichnet werden. Der Raum ist durch das Gehäuse, die verschlossenen und/oder abgedichteten Öffnungen in dem Gehäuse derart abgeschlossen, dass in dem Raum besondere Bedingungen hergestellt werden können. Dazu gehören gegenüber der Umgebung veränderte Druckverhältnisse wie Unterdruck oder Überdruck, die Einbringung technischer Gase und/oder Chemikalien, die Anwendung veränderter Temperaturen, von Magnetfeldern, die Verhinderung des Eintrittes von Licht oder die Schaffung besonderer Lichtverhältnisse sowie Kombinationen dieser Bedingungen.

Der abgeschlossene Raum kann mit der Atmosphäre, peripheren Anlagen und/oder Komponenten sowie mit anderen abgeschlossenen Räumen verbunden sein, und zwar vorzugsweise mittels Ventilen, Schleusen und/oder Klappen oder direkt ohne eine dichtende Verbindung.

Der abgeschlossene Raum muss nicht ortsfest sein. Er kann beispielsweise Fahr-, Schwenk- und Hubbewegungen unterworfen sein.

Sind eine erste Handhabungsvorrichtung, die die Hauptebene aufweist, und eine zweite Handhabungsvorrichtung, die die Gegenebene aufweist, vorhanden, kann die Vorrichtung besonders vorteilhaft in folgender Weise eingesetzt werden:
- *Bearbeitung und*/*oder Verarbeitung und*/*oder Veredelung von Substraten:* Das Substrat läuft in die Hauptebene ein (Transportbewegung) und wird durch eine Querbewegung der Hauptebene zur Gegenebene befördert. Das Substrat, das sich zwischen den beiden Ebenen befindet, kann nun bearbeitet, verarbeitet und/oder veredelt werden, wobei die hierfür erforderlichen Einrichtungen auf einer oder beiden Hubeinrichtungen oder außerhalb der Hubeinrichtungen in dem abgeschlossenen Raum angeordnet sein können. Für diese Bearbeitung, Verarbeitung oder Veredelung können auch die Kräfte der Antriebe einer oder beider Ebenen dazu genutzt werden. Wird das Substrat so gegen die Gegenebene gepresst, dass es nicht verrutschen kann, so kann beispielsweise auch der abgeschlossene Raum bewegt werden, beispielsweise kann eine Schwenkbewegung des gesamten abgeschlossenen Raumes ausgeführt werden.
- *Handling von Substraten:* Das Substrat läuft in die Hauptebene ein (Transportbewegung), wird durch eine Querbewegung der Hauptebene zur Gegenebene befördert und an diese übergeben. Der Weitertransport erfolgt mit einem entsprechenden Querversatz. Dazu können in der Gegenebene Halteeinrichtungen zum Halten des Substrates, beispielsweise Sauger, mechanische Klemmungen und andere, vorgesehen sein.

Diese Anwendung der erfindungsgemäßen Vorrichtung ist besonderes geeignet zur Realisierung eines Registers, Lagers oder Verteilers, bei dem die Substrate in mehrere Ebenen (Levels, Niveaus, Plattformen, Transportsysteme) befördert werden, um dort gelagert oder weitertransportiert zu werden.
- *Temperierung von Substraten:* Das Substrat läuft in die Hauptebene ein (Transportbewegung) und wird durch eine Querbewegung der Hauptebene zur gegenüberliegenden Gegenebene befördert. Dort wird das Substrat temperiert, d. h. gekühlt und/oder erhitzt, was sowohl flächig als auch partiell geschehen kann. Die hierfür erforderlichen Einrichtungen können auf einer oder beiden Hubeinrichtungen oder außerhalb der Hubeinrichtungen in dem abgeschlossenen Raum angeordnet sein. Sind sowohl in dem ersten Hubelement, das die Hauptebene umfasst, als auch in dem Hubelement, das die Gegenebene umfasst, Einrichtungen zur Temperierung des Substrates vorgesehen, so kann die Temperierung des Substrates beidseitig erfolgen.
- *Test von Substraten:* Das Substrat läuft in die Hauptebene ein (Transportbewegung) und wird durch eine Querbewegung der Hauptebene zur gegenüberliegenden Gegenebene befördert. Dort wird das Substrat Testprozessen unterzogen. Die hierfür erforderlichen Einrichtungen können auf einer oder beiden Hubeinrichtungen oder außerhalb der Hubeinrichtungen in dem abgeschlossenen Raum angeordnet sein.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische Darstellung der Lage eines flächigen Substrates in einer Ausführungsform der erfindungsgemäßen Vorrichtung;
- Fig. 2a-c: schematische Seitenansichten einer Ausführungsform der erfindungsgemäßen Vorrichtung in unterschiedlichen Lagen in der Umgebung;
- Fig. 3: eine schematische Seitenansicht einer Ausführungsform einer erfindungsgemäßen Handhabungseinrichtung;
- Fig. 4: eine schematische Ansicht der Anordnung der Stellelemente in Bezug auf die Hauptebene von oben;
- Fig. 5: eine schematische Darstellung von Konturen der ersten und/oder zweiten Ebene und mögliche Segmentierungen dieser Ebenen;
- Fig. 6: eine schematische geschnittene Seitenansicht eines Ausschnittes einer erfindungsgemäßen Handhabungseinrichtung;
- Fig. 7: eine schematische geschnittene Seitenansicht des in Fig. 6 gezeigten Ausschnittes einer erfindungsgemäßen Handhabungseinrichtung, wobei zusätzlich das Hubelement einer zweiten Handhabungseinrichtung, das die Gegenebene umfasst, gezeigt ist;
- Fig. 8: eine schematische Seitenansicht einer weiteren Ausführungsform einer erfindungsgemäßen Handhabungseinrichtung;
- Fig. 9: eine Seitenansicht einer weiteren Ausführungsform einer Handhabungseinrichtung, die Führungen für das Hubelement aufweist;
- Fig. 10: eine Ansicht des Hubelementes der in Fig. 9 gezeigten Ausführungsform der Handhabungseinrichtung von unten;
- Fig. 11: eine Ansicht des Hubelementes der in Fig. 9 gezeigten Ausführungsform der Handhabungseinrichtung von oben;
- Fig. 12: Detailansichten der Zentralführung (Fig. 12a: Seitenansicht; Fig. 12b: Ansicht von unten) und
- Fig. 13: eine schematische Seitenansicht eines Ausschnittes einer Ausführungsform einer Handhabungseinrichtung mit einem Hubelement, das Transportwalzen aufweist.

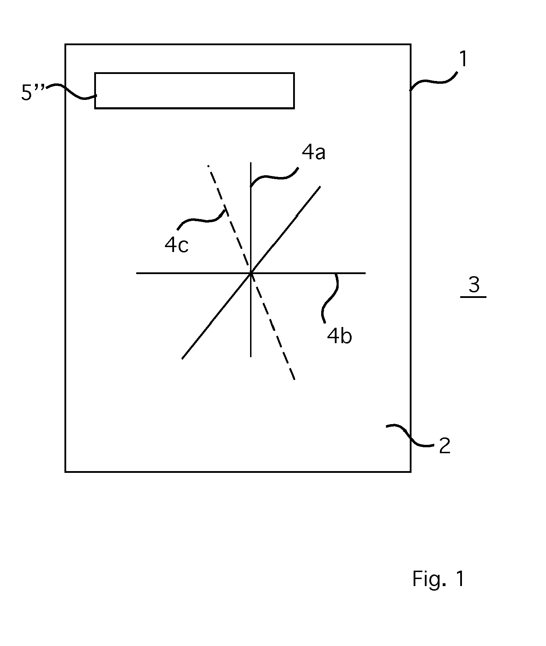

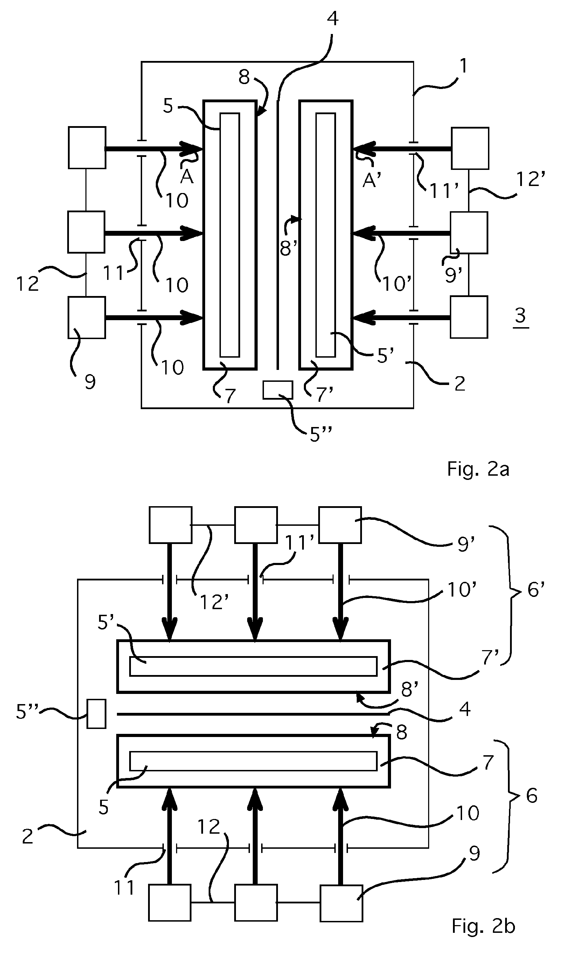

Die Figuren 1 und 2a bis 2c sind Prinzipskizzen einer ersten Ausführungsform der erfindungsgemäßen Vorrichtung. Wie in Fig. 1 gezeigt, umfasst die Vorrichtung ein Gehäuse 1, das einen abgeschlossenen Raum 2 in allen Richtungen umgrenzt und damit von der Umgebung 3 abgrenzt. In den abgegrenzten Raum 2 kann ein flächiges Substrat 4 über verschließbare Öffnungen (nicht gezeigt) in dem Gehäuse 1 eingebracht werden. In Fig. 1 ist das flächige Substrat 4 in verschiedenen Lagen gezeigt: in vertikaler Lage 4a, in horizontaler Lage 4b und in einer beliebigen Winkellage 4c. In dem abgeschlossenen Raum 2 sind ferner Einrichtungen 5 zur Bearbeitung und/oder Behandlung des Substrates 4 angeordnet. Die Einrichtungen 5 zur Bearbeitung und/oder Behandlung des Substrates 4 werden im Folgenden auch als Behandlungseinrichtungen 5 bezeichnet. In Fig. 1 ist zu erkennen, dass in dem abgeschlossenen Raum 2 die Lage des flächigen Substrates 4 nach Belieben verändert werden kann, und zwar unter Einsatz der erfindungsgemäßen Handhabungseinrichtungen.

Die Wirkungsweise der Handhabungseinrichtungen ist in den Figuren 2a bis 2c gezeigt. Dabei sind jeweils zwei Handhabungsvorrichtungen 6, 6' (siehe Fig. 2b) dargestellt, obwohl nach Maßgabe der Erfindung die Vorrichtung auch nur eine Handhabungseinrichtung umfassen kann.

Wie in den Figuren 2a bis 2c gezeigt, umfasst eine Handhabungseinrichtung 6 ein Hubelement 7, das eine Fläche 8 aufweist, die dem flächigen Substrat 4 zugewandt ist. Die Fläche 8 ist die Hauptebene. Ferner umfasst die Handhabungseinrichtung 6 Antriebe 9 und Stellelemente 10, die die von den Antrieben 9 erzeugte Bewegung auf das Hubelement 7 übertragen. Dazu sind in dem Gehäuse 1 Durchführungen 11 vorgesehen, durch die die Stellelemente 10 geführt sind. Die Durchführungen 11 sind abgedichtet, um einen Kontakt zwischen dem abgeschlossenen Raum 2 und der Umgebung 3 zu verhindern. Geeignete Durchführungen sind beispielsweise Membranbalge. Die Antriebe 9 können eine Bewegung des Hubelementes 7 in Richtung der Flächennormalen der Hauptebene bewirken. In den Figuren 2a bis 2c ist dies durch Pfeile A dargestellt, die gleichzeitig die Kraft veranschaulichen, die über die Antriebe mittels des Hubelementes 7 auf das Substrat 4 ausgeübt werden kann. Ebenso können die Antriebe 7 eine Bewegung entgegengesetzt zur Pfeilrichtung A bewirken. Zur Koordination der Antriebe 7 sind Steuereinrichtungen 12 vorgesehen.

Es ist in den Figuren 2a bis 2c zu erkennen, dass die Antriebe 9 der Handhabungseinrichtung 6 außerhalb des abgeschlossenen Raumes in der Umgebung 3 angeordnet sind, während die Hubelemente 7 mit der Hauptebene 8 in dem abgeschlossenen Raum 2 angeordnet sind. Diese räumliche Trennung von Antrieb und Ebene ist einer der Vorteile der vorliegenden Erfindung. Die Antriebe können beispielsweise Motoren, wie Stellmotoren sein.

Das Hubelement 7 kann Behandlungseinrichtungen 5 aufweisen, die in das Hubelement 7 integriert sind und Teile der Hauptebene 8. In dem abgeschlossenen Raum können weitere Behandlungseinrichtungen 5" angeordnet sein, die nicht in das Hubelement 7 integriert sind.

In den Figuren 2a bis 2c ist zusätzlich zu der ersten Handhabungseinrichtung 6 eine zweite Handhabungseinrichtung 6' (siehe Fig. 2b) vorgesehen. Der Aufbau dieser Handhabungseinrichtung 6' entspricht dem Aufbau der Handhabungseinrichtung 6. Den Bezugszeichen, die Elemente der zweiten Handhabungseinrichtung 6' zeigen, denen Elemente der ersten Handhabungseinrichtung 6 entsprechen, wurde demzufolge ein Strich hinzugefügt. Die zweite Handhabungseinrichtung 6' umfasst ein Hubelement 7', das eine Fläche 8' aufweist, die die Gegenebene bildet. Die Gegenebene 8' ist gegenüber der Hauptebene 8 angeordnet und verläuft parallel zu dieser. Zwischen der Hauptebene 8 und der Gegenebene 8' befindet sich das Substrat. Mit anderen Worten, die Hauptebene 8 ist einer Flächenseite des Substrates 4 zugewandt, während die Gegenebene 8' der anderen Flächenseite des Substrates 4 zugewandt ist. Das Substrat 4 wird von dem Hubelement 7, dem Hubelement 7' oder beiden Hubelementen 7, 7' gehalten.

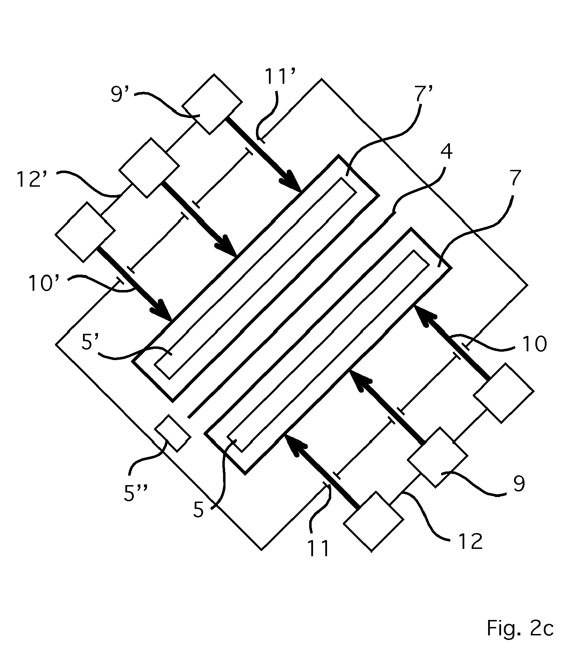

In Fig. 2a verlaufen die Hauptebene 8, die Gegenebene 8' und das flächige Substrat 4 in der Vertikalen, was der mit dem Bezugszeichen 4a gekennzeichneten Lage des Substrates 4 in Fig. 1 entspricht. In Fig. 2b verlaufen die Hauptebene 8, die Gegenebene 8' und das flächige Substrat 4 in der Horizontalen, was der mit dem Bezugszeichen 4b gekennzeichneten Lage des Substrates 4 in Fig. 1 entspricht. In Fig. 2c verlaufen die Hauptebene 8, die Gegenebene 8' und das flächige Substrat 4 in einer Winkellage zur Vertikalen und zur Horizontalen, was der mit dem Bezugszeichen 4c gekennzeichneten Lage des Substrates 4 in Fig. 1 entspricht. Damit veranschaulichen die Figuren 1 und 2a bis 2c, dass die Bewegung der Hauptfläche 8 und der Gegenfläche 8' erfindungsgemäß entlang ihrer Flächennormalen erfolgen soll, während der abgeschlossene Raum 2 jede beliebige Lage in der Umgebung 3 einnehmen kann.

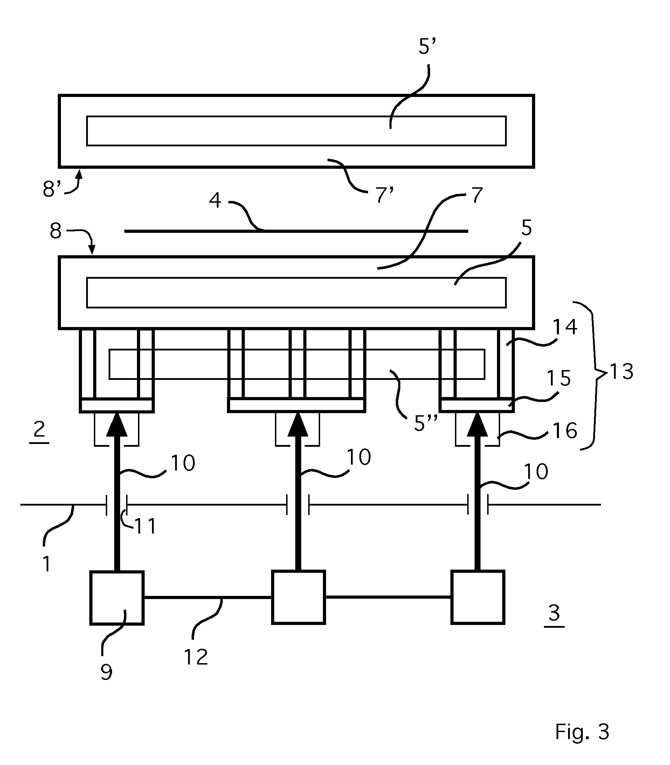

Fig. 3 zeigt einen Ausschnitt einer Ausführungsform der erfindungsgemäßen Vorrichtung. Zu erkennen sind die Handhabungseinrichtung 6, das Hubelement 7' der Handhabungseinrichtung 6' mit der Gegenebene 8' sowie ein Teil des Gehäuses 1, das den abgeschlossenen Raum 2 von der Umgebung 3 trennt.

Das Hubelement 7 der Handhabungseinrichtung 6 ist in der gezeigten Ausführungsform ein plattenförmiges Gebilde mit einer Oberfläche, die die Hauptebene 8 bildet. An der Oberfläche des Hubelementes 7, die der Hauptebene 8 gegenüberliegt, (in Fig. 3 ist dies die Unterseite des Hubelementes 7) sind Verstärkungen 13 ausgebildet, die die Steifigkeit des Hubelementes 7 und damit der Hauptebene 8 gewährleisten sollen. In der gezeigten Ausführungsform umfassen die Verstärkungen mehrere parallel zur Flächennormalen verlaufende und voneinander beabstandete Stege 14 gleicher Länge, die sich von der Unterseite des Hubelementes 7 zu einem orthogonal zu den Stegen 14 verlaufenden Träger 15 erstrecken. Jeder Träger 15 ist über ein Stellelement 10 mit einem Antrieb 7 verbunden. Das Stellelement 10 ist beispielsweise eine Welle, Achse oder Stange. Die Längsachse des Stellelementes 10 verläuft dabei orthogonal zur Ebene 8. Ein Ende eines solchen Stellelementes 10 ist dabei an dem Träger 15 befestigt, während das andere Ende in Kontakt mit dem Antrieb 9 steht. Es ist jedoch nicht zwingend erforderlich, dass jeder Träger mit einem Antrieb 7 verbunden ist. Solche Träger hat haben eine zusätzlich versteifende Wirkung.

Jede Handhabungseinrichtung umfasst vorzugsweise Sicherungselemente, insbesondere eine Rückzugssicherung. Eine solche Rückzugssicherung 16 ist besonders dann zweckmäßig, wenn die durch Pfeil A gekennzeichnete Bewegung des Hubelementes 7 mit der Richtung der Erdanziehungskraft zusammenfällt. Die Sicherungselemente verhindern eine Bewegung der Hauptebene 8 ohne die Einwirkung der Antriebe 9. Die Sicherungselemente sind dabei vorzugsweise so gestaltet, dass sie eine thermische Ausdehnung der Hauptebene 8 in x- und/der y-Richtung nicht behindern.

Bei der in Fig. 3 gezeigten Ausführungsform der erfindungsgemäßen Vorrichtung ist am Ende des Stellelementes 10, das an dem Träger 15 befestigt ist, eine Rückzugssicherung 16 vorgesehen. Dabei kann es sich um eine Klammer oder eine Kulisse handeln.

In Fig. 3 sind Verstärkungen 13 und Rücksicherungen 16 nur im Zusammenhang mit der Handhabungseinrichtung 6 gezeigt. Ebenso kann die zweite Handhabungseinrichtung 6', die die Gegenebene 8' umfasst, derartige Verstärkungen und Rücksicherungen aufweisen, wobei an die Stelle der Hauptebene die Gegenebene tritt.

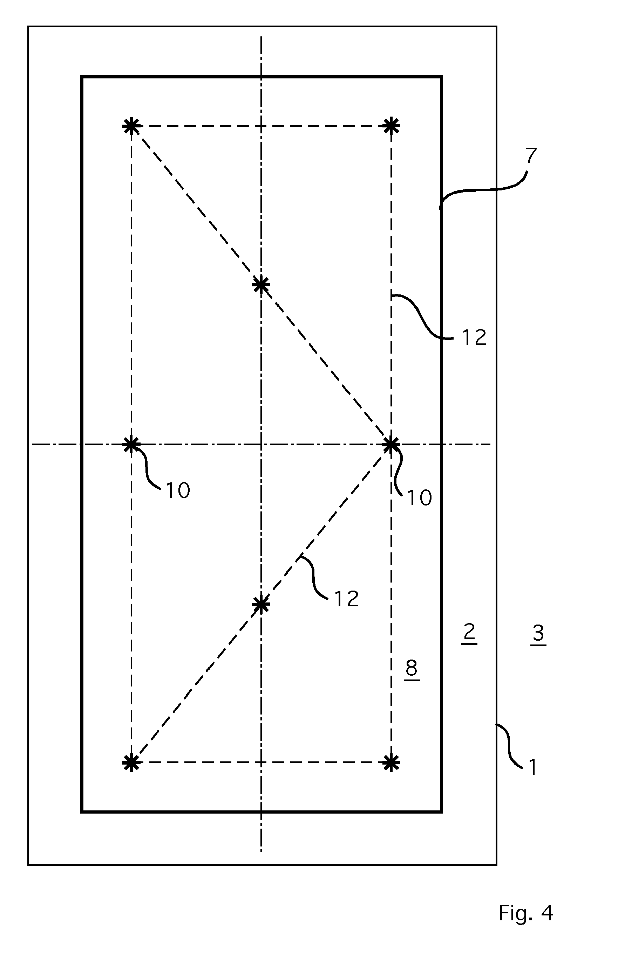

Fig. 4 veranschaulicht die Anordnung der Stellelemente 10 einer Handhabungseinrichtung 6 in Bezug auf die Hauptebene 8. Gezeigt ist die Draufsicht auf die Ebene 8 des Hubelementes 7. Die Stellelemente 10, die sich jeweils an ihren Enden in Kontakt mit der Unterseite eines Hubelementes 7 oder einem Träger 15 befinden und deren Längsachse orthogonal zur Ebene 8 verläuft, übertragen die Bewegung der Antriebe 9 auf das Hubelement 7, wodurch die Ebene 8 in Richtung ihrer Flächennormalen bewegt wird. Die Stellelemente 10 sind dabei in Bezug auf die Hauptebene 8 gleichmä-ßig verteilt, so dass die von Antrieben 7 erzeugte Kraft gleichmäßig auf das Hubelement 7 einwirken kann, was eine exakte und gleichmäßige Bewegung der Ebene 8 bewirkt. In Fig. 4 sind die Lage der Stellelemente 10 in der Ebene 8 durch Sterne gekennzeichnet. Die gestrichelte Linie zeigt die Steuereinrichtungen 12, die eine Synchronisation der Antriebe 9 und damit der Bewegung der Stellelemente 10 bewirken. Eine solche Anordnung der Stellelemente kann auch für die Handhabungseinrichtung 6' mit der Gegenebene 8' vorgesehen sein.

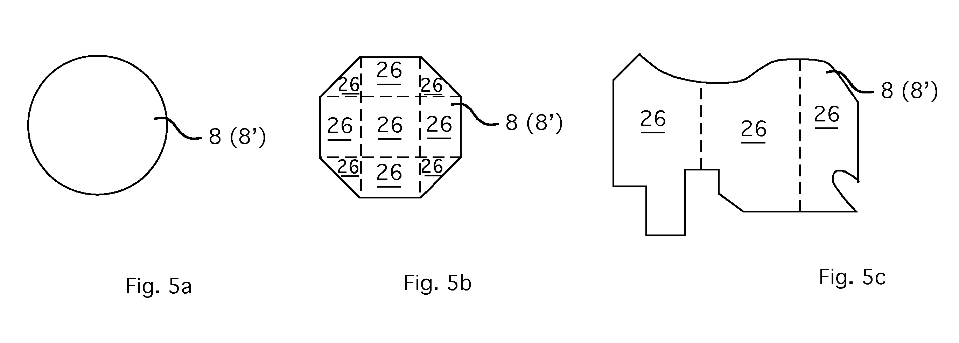

In Fig. 5 sind Konturen der Ebene 8 gezeigt, wobei die Gegenebene 8' ebenso solche Konturen aufweisen kann. Beispielsweise kann die Ebene eine runde, achteckige oder polygonale Kontur aufweisen. Die Ebenen 8, 8' können jeweils aus Teilflächen 26 zusammengesetzt sein (siehe Figuren 5a und 5b). Beispielsweise kann das Hubelementes 7, 7' aus miteinander verbundenen Segmenten zusammengesetzt sein, was die Stabilität erhöht und Fertigung und Handhabung der Hubelemente vereinfacht.

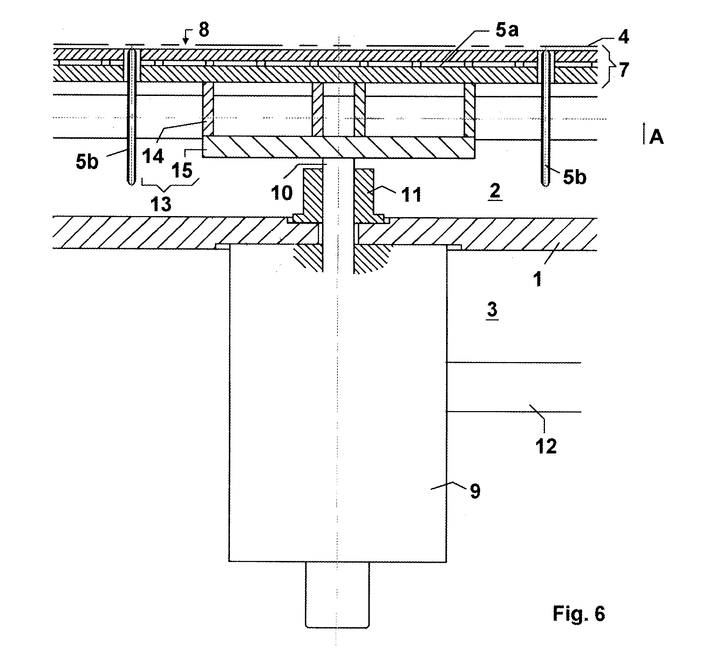

Fig. 6 zeigt einen Ausschnitt einer erfindungsgemäßen Handhabungseinrichtung 6 in schematischer Darstellung, wobei die Handhabungseinrichtung der in Fig. 4 gezeigten Handhabungsvorrichtung entspricht, wobei zusätzlich gezeigt ist, dass das Hubelement 7 ein plattenförmiger Hohlkörper ist, wobei in den Hohlraum eine Behandlungseinrichtung 5a, beispielsweise eine Temperiereinrichtung wie Kühlung oder Heizung, eingebracht ist. Ferner umfasst die Handhabungseinrichtung zusätzlich Behandlungseinrichtungen 5b, die eine Transportbewegung des Substrates 4 auf der Hauptebene 8 bewirken können. Die sind scheibenförmig aufgebaut, wobei an den Mantelflächen der Scheiben Auflagen aus Kunststoff ausgebildet sind, die in Kontakt mit der Unterseite des Substrates 4 gelangen können. In der Hauptebene 8 sind Öffnungen ausgebildet, durch die die Behandlungseinrichtungen 5b geführt sind, damit diese in Kontakt mit dem Substrat 4 gelangen können.

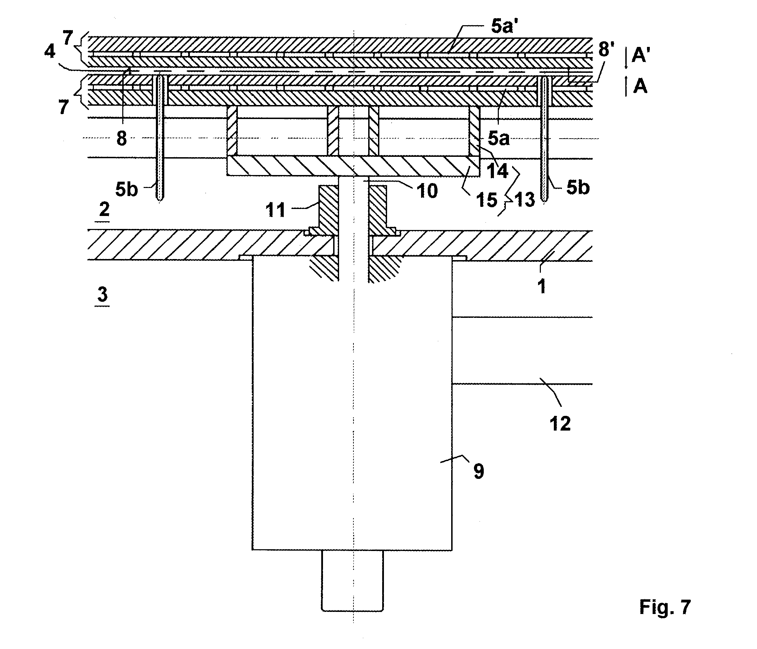

In Fig. 7 ist zusätzlich noch das Hubelement 7' der zweiten Handhabungseinrichtung 6' gezeigt, das die Gegenebene 8, bildet. Das Hubelement 7' kann ebenso wie das Hubelement 7 ein plattenförmiger Hohlkörper sein, in dessen Hohlraum eine Behandlungseinrichtung 5a', beispielsweise eine Temperiereinrichtung wie Kühlung oder Heizung, eingebracht ist.

Die Pfeile A und A' veranschaulichen eine Bewegung der beiden Ebenen 8, 8' entlang ihrer Flächennormalen in entgegengesetzter Richtung. In diesem Falle wirken die Kräfte der Antriebe 9, 9' in Pfeilrichtung A, A' auf das Substrat ein. Allerdings können die beiden Ebenen 8, 8' unabhängig voneinander in entgegengesetzter Richtung zur Richtung der Pfeile A, A' bewegt werden. Mit anderen Worten, beide Ebenen 8, 8' können unabhängig voneinander in Pfeilrichtung A, A' oder entgegengesetzt dazu bewegt werden, solange die Bewegung entlang der Flächennormalen der jeweiligen Ebenen 8, 8' erfolgt, wie die auch in den Figuren 2a bis 2c gezeigt ist.

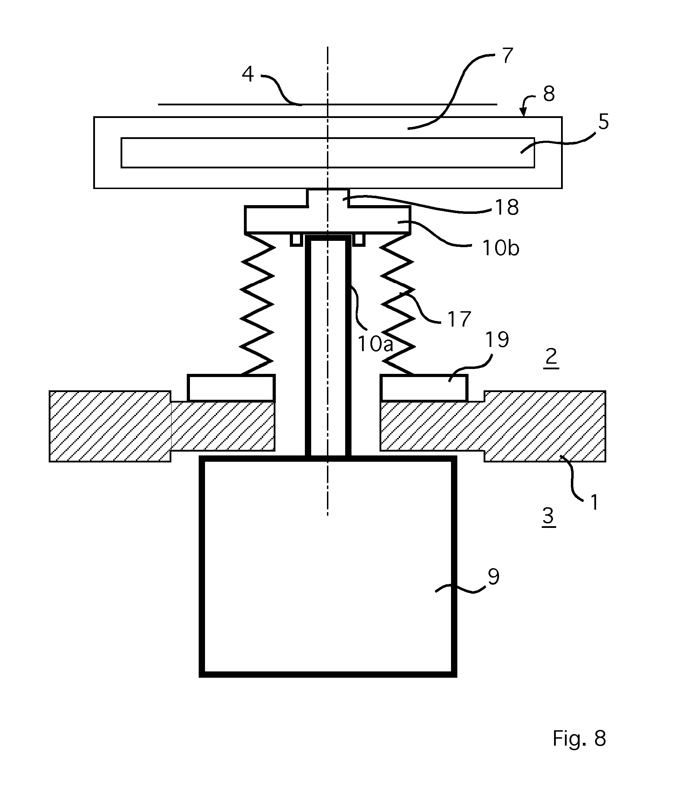

Bei der in Fig. 8 gezeigten Ausführungsform der erfindungsgemäßen Vorrichtung wird die Durchführung mittels eines Membranbalges 17 und zwei Stellelementen 10a, 10b realisiert. Dabei befindet sich das erste Stellelement 10a außerhalb des abgeschlossenen Raumes 2, während sich das zweite Stellelement 10b in den abgeschlossenen Raum 2 erstreckt und einen beweglichen Teil des Gehäuses 1 bildet. Das erste Stellelement 10a ist beispielsweise eine Kolbenstange, deren Ende auf das zweite Stellelement 10b einwirkt. Dabei wird das zweite Stellelement 10b in Richtung der Flächennormalen der Hauptebene 8 bewegt. Die Dichtheit des Gehäuses 1 wird durch einen Membranbalg 17 gewährleistet. Der Membranbalg hat einen im Wesentlichen rohrförmigen Querschnitt, wobei die eine Stirnseite dieses rohrartigen Gebildes von dem zweiten Stellelement 10b verschlossen ist, während die andere Stirnseite an den - im Verhältnis zu den Stellelementen starren ― Teil des Gehäuses 1 über einen Flansch 19 befestigt ist. Der Membranbalg 17 ist somit nur an einer Stirnseite geöffnet. In diese Öffnung ist das erste Stellelement 10a eingeführt, so dass sich ein Ende des ersten Stellelementes 10a in Kontakt mit der Unterseite des zweiten Stellelementes 10b befindet. An der Oberseite des zweiten Stellelementes 10b ist wiederum ein Steg 18 ausgebildet, der an die Unterseite des Hubelementes 7 angrenzt. Ein Membranbalg besteht typischerweise aus mehreren Membranpaaren. Die Membranbalge bestehen vorzugsweise aus Edelstahl. Die Ausdrücke "oben" und unten" beziehen sich lediglich auf die in Fig. 8 gezeigte Darstellung und sollen nur die Lage der Komponenten zueinander kennzeichnen.

Die in Fig. 8 beschriebene Durchführung kann auch für die zweite Handhabungseinrichtung 6' verwendet werden.

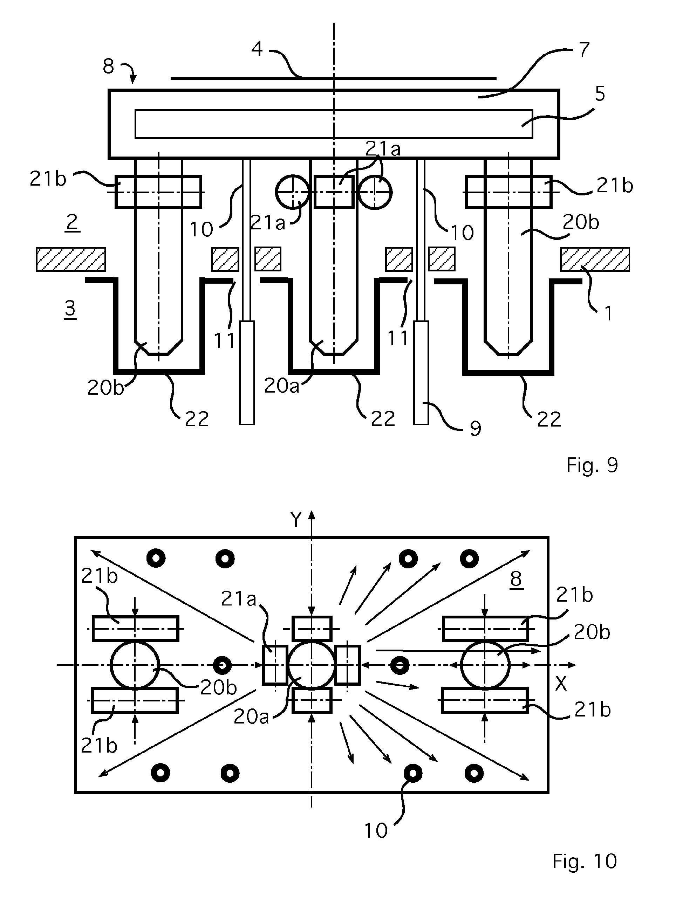

Die Figuren 9 bis 12 zeigen eine Ausführungsform einer Handhabungseinrichtung 6, die Führungen für das Hubelement 7 aufweist. Diese Führungen umfassen Führungsstangen 20a, 20b, die sich von der Unterseite des Hubelementes 7 in orthogonaler Richtung in Bezug auf die Ebene 8 erstrecken. Die Führungsstangen 20a, 20b sind zwischen Führungsrollen 21a, 21b gespannt, deren Drehachsen orthogonal zur Längsachse der Führungsstangen 20a, 20b verlaufen und deren Mantelflächen sich in Kontakt mit den Führungsstangen 20a, 20b befinden. In dem Gehäuse 1 sind Hauben 22 vorgesehen, die einen Teil der Führungsstangen 20a, 20b aufnehmen. Die Kontaktstellen zwischen den Hauben 22 und dem Gehäuse 1 sind durch Dichtungen 23 verschlossen.

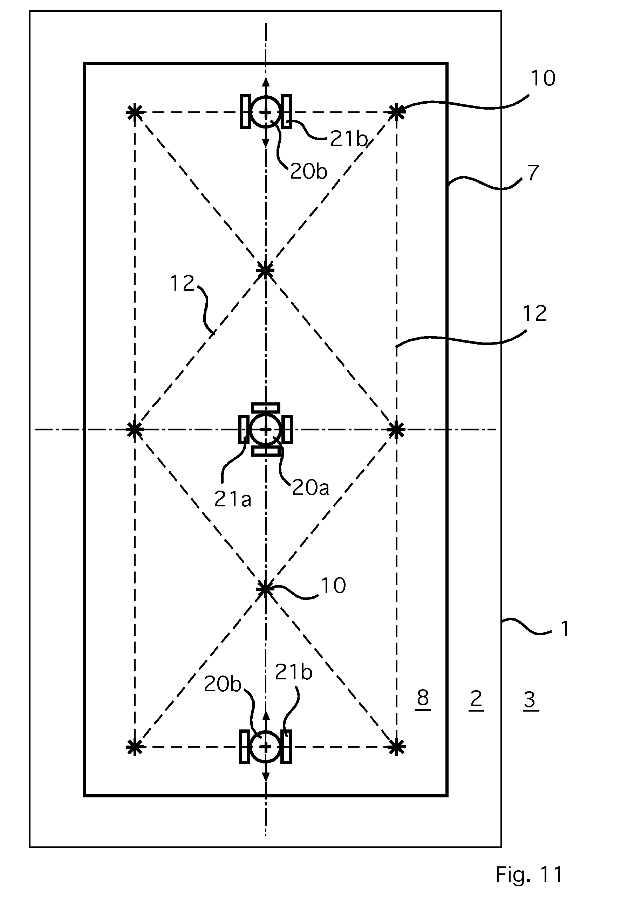

In den Figuren 10 und 11 ist zu erkennen, dass die mittig zur Ebene angeordnete Führungstange 20a zusammen mit den Lagern 21a ein Festlager ist, das die Zentralführung darstellt. Das Festlager besitzt vier Führungsrollen, deren Drehachsen in einer Ebene liegen, wobei die Drehachsen benachbarter Führungsrollen in einem Winkel von 90° zueinander verlaufen. Die beiden übrigen Führungen mit den Führungsstangen 20b und den Führungsrollen 21b sind Loslager. Beide Loslager besitzen jeweils zwei Führungsrollen 21b, deren Drehachsen in einer Ebene liegen, wobei die Drehachsen beider Führungsrollen 21b parallel zueinander verlaufen. Die Loslager ermöglichen die Ausdehnung der Ebene 8 in x-Richtung.

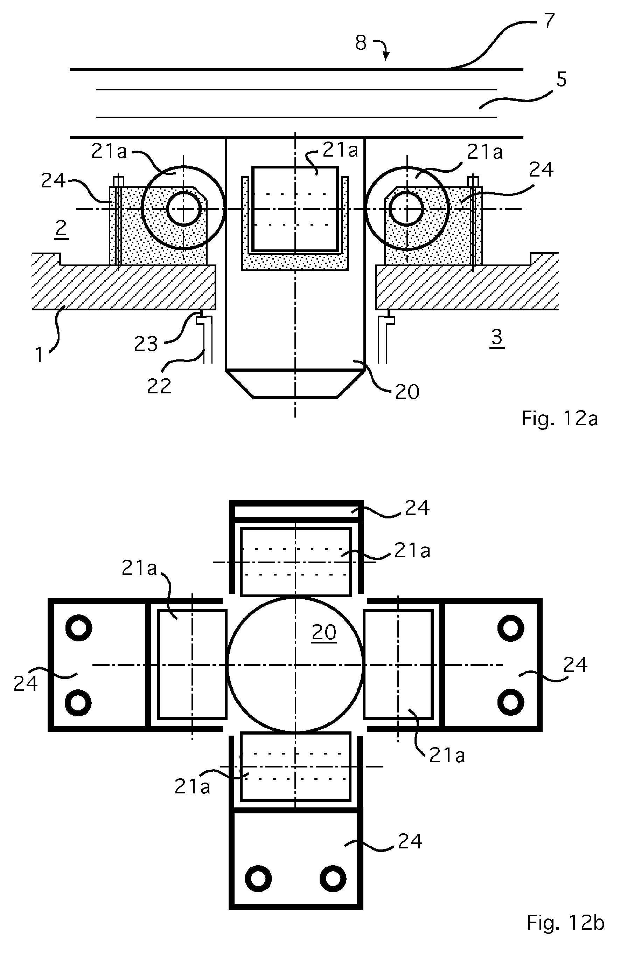

Die Führungsrollen für das Festlager und die Nebenlager sind, wie dies für die Zentralführung in den Figuren 12a und 12b gezeigt ist, drehbar an Lagerblöcken 23 befestigt, wobei die Lagerblöcke wiederum an dem Gehäuse 1 befestigt sind.

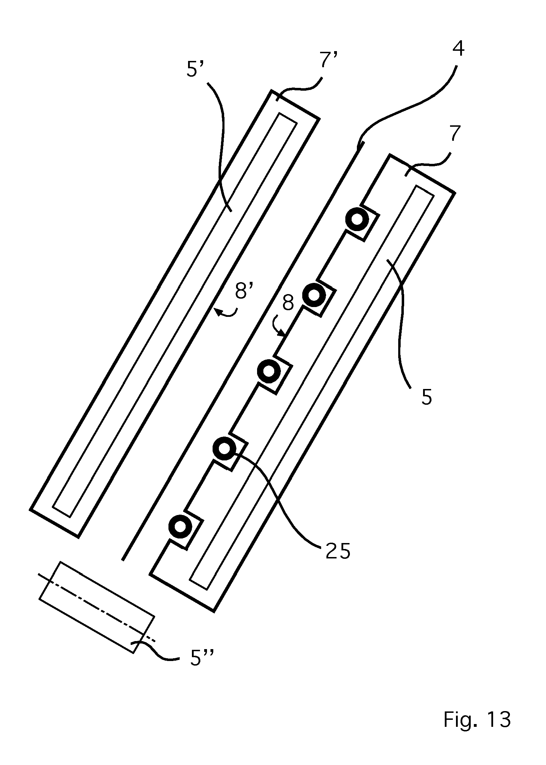

Fig. 13 zeigt eine Ausführungsform eines Hubelementes 7, bei dem eine Behandlungseinrichtung 5 in Form von Stützrollen 25 vorgesehen ist. Die Stützrollen 25 ermöglichen den Transport des Substrates 4 parallel zur Ebene 8, wobei die Drehachsen der Stützrollen 25 parallel zur Flächennormalen der Ebene 8 verlaufen und die Mantelflächen der Stützrollen 25 in Kontakt mit dem Substrat gelangen können.

Die in Bezug auf die einzelnen Ausführungsformen der erfindungsgemäßen Vorrichtung beschriebenen Merkmale können vom Fachmann ohne weiteres kombiniert werden, sofern dies nicht ausdrücklich ausgeschlossen worden ist.

### Bezugszeichenliste

- 1: Gehäuse
- 2: abgeschlossener Raum
- 3: Umgebung
- 4: flächiges Substrat
- 5: Behandlungseinrichtung
- 6: Handhabungseinrichtung
- 7: Hubelement
- 8: Hauptebene
- 8': Gegenebene
- 9: Antrieb
- 10: Stellelement
- 10a: erstes Stellelement
- 10b: zweites Stellelement
- 11: Durchführung
- 12: Steuereinrichtung
- 13: Verstärkung
- 14: Steg
- 15: Träger
- 16: Rückzugssicherung
- 17: Membranbalg
- 18: Steg
- 19: Flansch
- 20: Führungsstange
- 21: Führungsrolle
- 22: Haube
- 23: Dichtung
- 24: Lagerblöcke
- 25: Stützrollen
- 26: Teilflächen

## Patentansprüche

1. Vorrichtung zur Behandlung und/oder Bearbeitung von Substraten (4), umfassend
- einen von einem Gehäuse (1) abgeschlossenen Raum (2) mit zumindest einer verschließbaren Öffnung zur Einbringung und/oder Ausbringung eines Substrates (4); und
- zumindest eine erste Handhabungseinrichtung (6) für das Substrat (4), wobei die erste Handhabungseinrichtung (6) eine erste Ebene (8) und zumindest einen Antrieb (9) zur Verschiebung der ersten Ebene (8) in Richtung zur Flächennormalen der ersten Ebene (8) aufweist,
**dadurch gekennzeichnet, dass** die erste Ebene (8) der ersten Handhabungseinrichtung (6) innerhalb des abgeschlossenen Raumes (2) angeordnet ist und dass der Antrieb (9) zur Verschiebung der ersten Ebene (8) außerhalb des abgeschlossenen Raums (2) angeordnet ist.

2. Vorrichtung nach Anspruch 1, **dadurch gekennzeichnet, dass** die Vorrichtung ferner eine zweite Handhabungseinrichtung (6') umfasst, die eine zweite Ebene (8') und zumindest einen Antrieb (9') zur Verschiebung der zweiten Ebene (8') in Richtung der Flächennormalen der zweiten Ebene (8') aufweist, wobei die zweite Ebene (8') der zweiten Handhabungseinrichtung (6') der ersten Ebene (8) der ersten Handhabungseinrichtung (6') gegenüberliegt.

3. Vorrichtung nach Anspruch 1, **dadurch gekennzeichnet, dass** die Vorrichtung ferner eine zweite Handhabungseinrichtung (6') umfasst, die eine zweite Ebene (8') aufweist, die in Richtung der Flächennormalen der zweiten Ebene (8') starr angeordnet ist.

4. Vorrichtung nach Anspruch 2 oder Anspruch 3, **dadurch gekennzeichnet, dass** das Substrat (4) zwischen der ersten Ebene (8) der ersten Handhabungseinrichtung (6) und der zweiten Ebene (8') der zweiten Handhabungseinrichtung (6') eingebracht ist.

5. Vorrichtung nach einem der vorstehenden Ansprüche, **dadurch gekennzeichnet, dass** zwei oder mehr Antriebe (9) zur Bewegung der erste Ebene (8) der ersten Handhabungseinrichtung (6) vorgesehen sind, wobei jeder der Antriebe (9) au-ßerhalb des geschlossenen Raumes (2) angeordnet ist.

6. Vorrichtung nach Anspruch 5, **dadurch gekennzeichnet, dass** die Antriebe (9), die zur Bewegung der ersten Ebene (8) vorgesehen sind, über Steuereinrichtungen (12) miteinander verbunden sind.

7. Vorrichtung nach einem der Ansprüche 2 oder 4 bis 6, **dadurch gekennzeichnet, dass** zwei oder mehr Antriebe (9') zur Bewegung der zweiten Ebene (8') der zweiten Handhabungseinrichtung (6') vorgesehen sind, wobei jeder der Antriebe (9') außerhalb des geschlossenen Raumes (2) angeordnet ist.

8. Vorrichtung nach Anspruch 7, **dadurch gekennzeichnet, dass** die Antriebe (9'), die zur Bewegung der zweiten Ebene (8') vorgesehen sind, über Steuereinrichtungen (12') miteinander verbunden sind.

9. Vorrichtung nach einem der vorstehenden Ansprüche, **dadurch gekennzeichnet, dass** das Gehäuse (1) für jeden Antrieb (9, 9') eine Durchführung (11, 11') aufweist, durch die ein Stellelement (10, 10') geführt ist, über das der Antrieb (9, 9') die Verschiebung der jeweiligen Ebene (8, 8') bewirkt.

10. Vorrichtung nach einem der vorstehenden Ansprüche, **dadurch gekennzeichnet, dass** eine Ebene (8, 8') die Außenseite eines in dem Gehäuse (1) angeordneten Hubelementes (7, 7') ist, wobei das Hubelement (7, 7') eine oder mehrere Einrichtungen (5, 5') aufweisen kann, die aus der Gruppe ausgewählt sind, die Kühlelemente, Heizelemente, Aktoren, Sensoren, Gaseinlässe, Verdampfer, Einrichtungen zur Beschichtung des Substrates, Einrichtungen zum Testen des Substrates, Beleuchtungselemente, Magnetsysteme, Messinstrumente, Einrichtungen zum Transport des Substrates und Kombinationen davon umfasst.

11. Vorrichtung nach einem der vorstehenden Ansprüche, **dadurch gekennzeichnet, dass** sie ferner Führungen (20, 21, 20', 21') für zumindest eine Ebene (8, 8') umfasst, wobei die Führungen die Bewegung der Ebene (8, 8') in Richtung ihrer Flächennormalen zulassen, eine Bewegung der Ebene (8, 8') in zumindest einer Richtung orthogonal zur Flächennormalen der Ebene (8, 8') verhindern.
